(19) Europäisches Patentamt
European Patent Office
Office européen des brevets

(11) Publication number: **0 388 537 B1**

(12) **EUROPEAN PATENT SPECIFICATION**

(45) Date of publication of patent specification: **25.08.93**

(51) Int. Cl.⁵: **G01R 29/00**, H03K 5/19, H03K 5/08, H04B 3/46, H04L 9/00, G01R 23/02

(21) Application number: **89203336.6**

(22) Date of filing: **29.12.89**

(54) **Method and device for determining a measured value indicating the degree to which data signals are reproducible outside a digital information processing system.**

(30) Priority: **30.12.88 NL 8803206**

(43) Date of publication of application:
**26.09.90 Bulletin 90/39**

(45) Publication of the grant of the patent:
**25.08.93 Bulletin 93/34**

(84) Designated Contracting States:
**DE FR GB NL**

(56) References cited:

**EP-A- 0 137 948**

**COMPUTERS & SECURITY. vol. 4, no. 4, December 1985, AMSTERDAM NL pages 269 - 276; W. van Eck: "Elctromagnetic Radiation from Video Display Units: An Eavesdropping Risk?"**

**PATENT ABSTRACTS OF JAPAN vol. 7, no. 38 (P-176)(1183) 16 February 1983,& JP-A-57 190273**

**ELECTRONICS. vol. 55, no. 5, March 1982, NEW YORK US pages 139 - 141; D.S. Jain: "'Demultiplexing' pulses of different widths"**

**ELEKTRONIK. vol. 31, no. 5, March 1982, MUNCHEN DE pages 71 - 73; D. Otto: "Breitbandige Gutemessung verzerrter Digitalsignale"**

(73) Proprietor: **Koninklijke PTT Nederland N.V.**
**P.O. Box 95321**
**NL-2509 CH The Hague(NL)**

(72) Inventor: **Smulders, Petrus Franciscus Maria**
**1 Asberg**
**NL-5508 DC Veldhoven(NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 388 537 B1

## Description

## A. Background of the invention

### 1. Field of the invention

The present invention relates to a measuring method and a device for determining a characteristic value indicating the degree to which data signals of a digital information processing system are reproducible outside that system.

### 2. Problems

In the neighbourhood of information processing and telecommunication systems, data signals, which are exchanged within that system, can, due to spurious electromagnetic emission outside the relevant system, to a greater or less degree, be received - in a wireless way - and, generally after the received signal has been restored, be reproduced and displayed. It is obvious that the more confidential the information content of the exchanged data is the greater said problem is.

The problem of receipt of data signals from spurious emission outside information processing systems is known from "Computers and Security", vol. 4, no. 4, December 1985, pages 269-276, the article entitled "Electromagnetic Radiation from Video Display Units: An Eavesdropping Risk?" by W. van Eck.

Document EP-A- 0 137 948 shows a prior art arrangement whereby an input signal is converted to positive and negative pulses by comparison with upper and lower thresholds. An integrator produces a saw-tooth signal of limited maximum amplitude in synchronism with the positive pulses.

## B. Summary of the invention

The present invention provides a measuring method as claimed in claim 1 and a device as claimed in claim 2 for determining in an unambiguous way to what degree an information processing or telecommunication system is susceptible to "tapping" information via electromagnetic emission.

A preferred embodiment of the device in accordance with the invention comprises a device for converting the binary signal into a saw-tooth shaped signal with ascending flanks, linearly increasing with the time, and steep descending flanks at times corresponding to the starting times of the pulses of the first binary value of the binary signal, a device for determining the relatively smallest peak amplitude of the saw-tooth shaped signal, a device for comparing the amplitudes of the consecutive peaks of the saw-tooth shaped signal with the determined relatively smallest peak amplitude, and a device for detecting and adding to one another the number of peaks of the saw-tooth shaped signal, the amplitude of which is equal, within a certain tolerance, to

$$\{(n * u_o) / 2\},$$

in which $u_o$ is said relatively smallest peak amplitude ($u_o$) and n a random natural number from the series {3,4,5,6,...}. In this preferred embodiment the respective times ($t_o$ and the respective time differences $t_x$ between the starting times of the consecutive pulses) are not compared with one another via conversion into numbers of time units, but via conversion into signal amplitudes, e.g. voltages ($u_x$), which can be compared with one another in a considerably simpler and quicker way.

According to a further working-out of the device indicated hereinabove it comprises a device for storing and comparing the respective characteristic values over more than one consecutive period of consideration, and for representing the greatest value of them. In this way - for a certain period of measuring consisting of more than one period of consideration - the greatest of the consecutive characteristic values per period of consideration is registered and displayed as a final characteristic value.

## C. Embodiments

### 1. Figures

Figure 1 shows part of a binary signal within an information processing system.

Figure 2 shows a signal received outside the information processing system, which signal is compared with a threshold value.

Figure 3 shows a binary signal resulting from the signal received and compared with the threshold value.

Figure 4 shows the data pulses detected by the device.

Figure 5 shows interference pulses and "periodic pulses" detected by the device.

Figure 6 shows a saw-tooth shaped voltage signal with steep descending flanks at times corresponding to the starting times of the pulses of the first binary value of the binary signal represented in figure 3, and with linearly increasing ascending flanks between them.

Figure 7 shows a diagrammatic representation of an embodiment of a device according to the invention.

## 2. Description

Figure 1

Figure 1 shows a binary signal 1 - during a period of time $t_o...t_3$ - which signal is transmitted within an information processing system - e.g. a computer network. The part of the signal 1 which is shown in the figure is successively positive for one clock period 2, zero for one clock period, positive for two clock periods, zero for one clock period, positive for one clock period, zero for three clock periods, positive for one clock period and zero for four clock periods. Particularly due to the steep flanks of the signal, the signal 1 is emitted to outside the information processing system in the form of an electromagnetic field, where it can be received by means of a radio receiver.

Figure 2 and figure 3

Figure 2 shows the course of a signal 3 received outside the information processing system by means of a radio receiver. Owing to among other things the shielding of the information processing system and external interference fields the received signal 3 considerably differs from the signal 1 shown in figure 1. Inter alia an interference pulse 4, which does not originate from the information processing system, is to be seen. The received signal 3 is processed in the device according to the invention in such a way that a signal is obtained which forms the best possible reflection of the original signal 1. For that purpose the received signal 3 is compared with a signal threshold 5, equal to about the average value of the received signal, due to which a distinction is achieved between parts of the received signal 3 which are greater (+) than and parts which are smaller (-) than the signal threshold 5. Figure 3 shows a binary signal 6 thus reconstructed.

The object of the measuring method and the device according to the present invention is to determine the degree to which an information processing system emits data signals in such a way that they can be reconstructed. Figure 3 shows a "restored" signal 6. In this respect it should be borne in mind that the received signal 3 has not only the information processing system to be investigated as a source, but that there can be other sources which are responsible for the signal 3. One can distinguish: sources transmitting periodic pulses, sources transmitting (accidental) interference signals and - as already mentioned - sources transmitting data pulses. Consequently, the task of the present measuring method and measuring device is to distinguish between data pulses and periodic or accidental signals. Data signals can contain periodic pulse combinations (e.g. 0101) as well as non-periodic pulse combinations (e.g. 1000). Because of the fact that it is, however, impossible to derive from the received signal 3 whether a periodic pulse combination originates from a data signal source or from a clock signal source, all the periodic pulse combinations are left out of consideration for the measuring , in other words, only non-periodic pulse combinations - of which it is practically sure that they originate from a data signal source, in this case the relevant information processing system - are regarded as originating from the information processing system. In order to distinguish between non-periodic data signals on the one hand and periodic (data or clock) signals or arbitrary interference signals on the other hand, the period times $t_x$ between the consecutive ascending flanks of the constructed signal 6 are subjected to the criterion

$$t_x = \{(n * t_o) / 2\} \quad (n = 3,4,5,...).$$

Before doing this the relatively shortest time to between two consecutive ascending flanks is determined. Subsequently, it is determined whether each of the other period times $t_x$ ($t_1...t_{3b}$ in figure 3) meets or does not meet said criterion. In figure 3 it is to be seen that over the period of consideration $t_o...t_3$ shown in this figure, the period to is the shortest period (it is obvious that this need not always be the first period). Period $t_1 = 1\frac{1}{2} *$ to, period $t_2 = 2 *$ to and period $t_3 = 2\frac{1}{2} * t_o$; period $t_3$ is, however, divided into a time $t_{3a}$ and a time $t_{3b}$, where $t_{3a} = a * t_o$ ($1\frac{1}{2} < a < 2$) and $t_{3b} = b * t_o$ ($1\frac{1}{2} < b < 2$). The pulses B and C (with the indication of time $t_1$ resp. $t_2$) meet the criterion $t_x = \{(n * t_o) / 2\}$, viz. for $n = 3$ resp. for $n = 4$, so that these pulses B and C are considered to be data pulses. Neither pulse A (with the indication of time $t_o$) nor the pulses D and E (with the indication of time $t_{3a}$ resp. $t_{3b}$) meet the criterion ($n = 2$), for which latter two pulses it applies that $3 < n < 4$.

Figures 4 and 5

The figures 4 and 5 indicate how the different pulses A up to E inclusive are classified by means of the above-mentioned algorithm. As already described hereinabove the pulses B and C are classified by the algorithm as non-periodic data pulses. This is represented in figure 4 by the status pulses I. In figure 5 the other pulses A, D and E (periodic or interference pulses) are represented by the status pulses II.

Figure 6

Figure 6 shows a saw-tooth shaped voltage signal with steep descending flanks at moments corresponding to the starting times of the ascending pulses of the binary signal represented in figure 3 and to linearly increasing ascending flanks between them. In this way the respective intervals of time $t_o$, $t_1$, $t_2$, $t_{3a}$ and $t_{3b}$ are converted into a voltage signal, the consecutive peak values $U_o$, $U_1$, $U_2$, $U_{3a}$ and $U_{3b}$ of which correspond to the length of time of those intervals. Owing to this, it is achieved that in a device for classifying pulses according to the aforesaid algorithm no times, but voltages can be compared with one another, which is feasible in a relatively simple way and works quickly.

Figure 7

Figure 7 shows a diagrammatic representation of an embodiment of a device according to the invention. Signals which are received via an aerial 8 and a receiver 9 are emitted (inter alia) by an information processing system 10. In a comparator 11 the signal 3 delivered by the receiver is compared with a reference signal 5, delivered by a reference signal generator 12. The comparator 11 delivers the binary signal 6 shown in figure 3, which signal is subsequently supplied to an integrator 13, where the binary signal 6 is integrated with the saw-tooth shaped signal 7 shown in figure 6. The binary signal 6 is also supplied to a differentiator 14, which delivers a pulse at each of the ascending flanks of the binary signal 6. The integrated signal 7 is supplied to a peak value detector 15, where the peak value of the signal is determined. The peak value signal is subsequently supplied to a comparator circuit 16, which is moreover connected to a peak value buffer 17. At each moment of an ascending flank of the binary signal 6 the comparator circuit 16 compares, under the control of the pulses delivered by the differentiator 14, the peak value stored in the peak value buffer 17 with the peak value signal delivered by the peak value detector 15. If the value of this peak value signal is smaller than the peak value stored in the buffer 17, the latter will be replaced by the peak value of the peak value signal; if the value of the peak value signal is greater than the value stored in the buffer 17, the latter will remain unchanged. In this way the peak value buffer 17 always contains the relatively smallest peak value corresponding to the peak value $u_o$ in figure 6, which value is in its turn a measure for the shortest time to between consecutive ascending flanks of the binary signal 6. The peak value signal originating from the peak value detector 15 is subsequently supplied to a counter 18, comprising three voltage windows for respectively $1\frac{1}{2}$, 2 and $2\frac{1}{2}$ times the peak value stored in the peak value buffer 17 (which peak value is also supplied to the counter 18). The voltage window is formed by a voltage divider, from which three reference voltages are derived, viz. $1\frac{1}{2}$, 2 and $2\frac{1}{2}$ times the peak value stored in the buffer, as well as by three comparators to which on the one hand said reference voltages are applied and on the other hand the peak value signal originating from the peak value detector 15. The output terminals of the comparators are connected via a network of logic gates to a 2-decade counter for counting the number of data pulses and to a 1-decade counter for counting the number of periodic or interference pulses. If a peak value corresponds to one of the three window values, the signal peak value is considered to represent a data pulse, and the 2-decade counter is increased by one counting unit. If the signal peak value does not correspond to one of the window values, the signal peak value is considered to represent a periodic (clock or data) signal or an interference signal, and the 1-decade counter is increased by one counting unit. The 2-decade counter is always reset after the 1-decade counter has counted ten non-data pulses. The highest state of the counter of the 2-decade counter is - prior to the resetting - transmitted to a maximum buffer 19. In this maximum buffer 19 the transmitted state of the counter is compared with the state of the counter already stored in this maximum buffer and the highest state of those two states is then stored in the maximum buffer 19. Finally this state of the counter stored in the maximum buffer 19 is transmitted on to a display 20, which displays the contents of the maximum buffer during the measuring and after it.

## Claims

**1.** A measuring method for determining a characteristic value indicating the degree to which data signals of a digital information processing system are reproducible outside that system, characterized

in that a signal (3) received outside the information processing system to be tested is compared with a threshold value (5) and is converted into a binary signal (6) with pulses of a first binary value as long as the received signal is greater than the threshold value, and pulses of a second binary value as long as the received signal is smaller than the threshold value, of which binary signal the relatively shortest time ($t_o$) between two consecutive starting times of the pulses of the first binary value is determined,

said characteristic value to be determined

being dependent upon a ratio of a number of data pulses and a number of non-data pulses, where data pulses are those pulses of the first binary value for which the time ($t_x$) between the starting time of that pulse of the first binary value and the starting time of the preceding pulse of the first binary value is, within certain tolerances, equal to $\{(n * t_o) / 2\}$, in which $t_o$ represents said relatively shortest time and n is a random natural number from the series {3,4,5,6,...}, and where non-data pulses are those pulses of the first binary for which this equality does not apply.

**2.** A device for carrying out the measuring method in accordance with claim 1, characterized by

means (8,9) for receiving signals outside a digital information processing system (10) to be tested,

means (11) for comparing a received signal (3) with a threshold value (5), and converting it into a binary signal (6), consisting of pulses of a first binary value as long as the received signal is greater than the threshold value, and pulses of a second binary value as long as the received signal is smaller than the threshold value,

means (13...17) for determining the relatively shortest time ($t_o$) between two consecutive starting times of the pulses of the first binary value,

means (18) for determining the number of data pulses, these being pulses of the first binary value for which it applies that the time ($t_x$) between the starting time of that pulse of the first binary value and the starting time of the preceding pulse of the first binary value is, within certain tolerances, equal to $\{(n * t_o) / 2\}$, in which $t_o$ represents said relatively shortest time and n is a random natural number from the series {3,4,5,6,...}, and for determining the number of non-data pulses, these being pulses of the first binary value for which this equality does not apply, and

means (18...20) for determining and representing the characteristic value referred to, which characteristic value depends upon a ratio between a number of data pulses and a number of non-data pulses.

**3.** A device in accordance with claim 2, characterized by

a converting device (13) for converting the binary signal (6) into a saw-tooth shaped signal (7) with ascending flanks linearly increasing with the time and steep descending flanks at times corresponding to the starting times of the pulses of the first binary value of the binary signal,

a device (16, 17) for determining the relatively smallest peak amplitude ($U_o$) of the saw-tooth shaped signal (4),

a device (18) for detecting and counting the number of peaks of the saw-tooth shaped signal, the amplitude of which is, within a certain tolerance, equal to

$\{(n * u_o) / 2\}$, in which $u_o$ is said relatively smallest peak amplitude ($u_o$) and n a random natural number from the series {3,4,5,6,...}.

**4.** A device in accordance with claim 3, characterized by a device (19) for comparing the respective characteristic values over more than one consecutive period of consideration, and for determining the greatest value of them.

## Patentansprüche

**1.** Messverfahren zur Bestimmung eines charakteristischen Wertes, der den Grad der Reproduzierbarkeit von Datensignalen ausserhalb eines Informationsverarbeitungssystems angibt, dadurch gekennzeichnet, dass
ein ausserhalb des zu testenden Informationsverarbeitungssystems empfangenes Signal (3) mit einem Schwellenwert (5) verglichen und in ein Binärsignal (6) umgewandelt wird, das, falls das empfangene Signal grösser ist als der Schwellenwert, Impulse von einem ersten Binärwert und falls das empfangene Signal kleiner ist als der Schwellenwert, Impulse von einem zweiten Binärwert enthält, wobei bei diesem Binärsignal die relativ kürzeste Zeit ($t_o$) zwischen Zwei aufeinanderfolgenden Anfangszeiten der Impulse des ersten Binärwerts bestimmt wird,
dass dieser zu bestimmende charakteristische Wert von einem Verhältnis zwischen einer Anzahl Datenimpulse und einer Anzahl datenfreier Impulse abhängig ist, wobei die Datenimpulse diejenigen Impulse des ersten Binärwerts sind, für die die Zeit ($t_x$) zwischen der Anfangszeit dieses Impulses des ersten Binärwerts und der Anfangszeit des vorhergehenden Impulses des ersten Binärwerts, innerhalb gewisser Toleranzen, gleich $\{(n*t_o)/2\}$ ist, wobei $t_o$ die erwähnte kürzeste Zeit darstellt und n eine zufällige natürliche Zahl der Reihe {3,4,5,6,...} ist, und wobei die datenfreien Impulse diejenigen Impulse des ersten Binärwerts sind, für die diese Gleichheit nicht gilt.

**2.** Einrichtung zur Ausführung des Messverfahrens nach Anspruch 1, gekennzeichnet durch:
Mittel (8, 9) zum Empfangen von Signalen ausserhalb eines zu testenden digitalen Informationsverarbeitungssystems (10);

Mittel (11) zum Vergleichen eines Empfangssignals (3) mit einem Schwellenwert (5) und zu dessen Umwandlung in ein Binärsignal (6), das, falls das Empfangssignal grösser ist als der Schwellenwert, aus Impulsen eines ersten Binärwerts und falls das Empfangssignal kleiner ist als der Schwellenwert, aus Impulsen eines zweiten Binärwerts besteht;

Mittel (13...17) zur Bestimmung der relativ kürzesten Zeit ($t_o$) zwischen zwei aufeinanderfolgenden Anfangszeiten der Impulse des ersten Binärwerts;

Mittel (18) zur Bestimmung der Anzahl Datenimpulse, welche Impulse des ersten Binärwerts sind, für die gilt, dass die Zeit ($t_x$) zwischen der Anfangszeit dieses Impulses des ersten Binärwerts und die Anfangszeit des vorhergehenden Impulses des ersten Binärwerts, innerhalb gewisser Toleranzen, gleich $\{(n^*t_o)/2\}$ ist, wobei $t_o$ die erwähnte kürzeste Zeit darstellt und n eine zufällige natürliche Zahl der Reihe {3,4,5,6,...} ist, und zur Bestimmung der Anzahl datenfreie Impulse, welche Impulse des ersten Binärwerts sind, für die diese Gleichheit nicht gilt, und

Mittel (18...20) zur Bestimmung und Darstellung dieses charakteristischen Wertes, wobei dieser charakteristische Wert von einem Verhältnis zwischen einer Anzahl Datenimpulse und einer Anzahl datenfreie Impulse abhängt.

**3.** Einrichtung nach Anspruch 2, gekennzeichnet durch:

eine Umwandlungsvorrichtung (13) zur Umwandlung des Binärsignals (6) in ein sägezahnförmiges Signal (7) mit aufsteigenden Flanken, die mit der Zeit linear anwachsen, und mit steil abfallenden Flanken in Zeitpunkten, welche den Anfangszeiten der Impulse des ersten Binärwerts des Binärsignals entsprechen;

eine Vorrichtung (16, 17) zur Bestimmung der relativ kleinsten Spitzenamplitude ($U_o$) des sägezahnförmigen Signals (4), und

eine Vorrichtung (18) zum Detektieren und Zählen der Anzahl der Spitzen des sägezahnförmigen Signals, dessen Amplitude, innerhalb gewisser Toleranzen, gleich $\{(n^*u_o)/2\}$ ist, wobei $u_o$ die relativ kleinste Spitzenamplitude ($u_o$) und n eine zufällige natürliche Zahl aus der Reihe {3,4,5,6,...} ist.

**4.** Einrichtung nach Anspruch 3, gekennzeichnet durch:

eine Vorrichtung (19) zum Vergleichen der jeweiligen charakteristischen Werte über mehr als eine aufeinanderfolgende Betrachtungsperiode und zur Bestimmung des grössten Wertes unter ihnen.

## Revendications

**1.** Procédé de mesure pour déterminer une valeur de caractéristique indiquant le degré selon lequel des signaux de données d'un système de traitement d'information numérique sont reproductibles à l'extérieur de ce système, caractérisé en ce qu'un signal (3) reçu depuis l'extérieur du système de traitement d'information à tester est comparé à une valeur de seuil (5) et est converti en un signal binaire (6) présentant des impulsions d'une première valeur binaire tant que le signal reçu est supérieur à la valeur de seuil et présentant des impulsions d'une seconde valeur binaire tant que le signal reçu est inférieur à la valeur de seuil et pour ce signal binaire, le temps le plus court de façon relative ($t_o$) entre deux instants de début consécutifs des impulsions de la première valeur binaire est déterminé,

ladite valeur de caractéristique qui doit être déterminée dépendant d'un rapport d'un nombre d'impulsions de données et d'un nombre d'impulsions de non données où les impulsions de données sont les impulsions de la première valeur binaire pour lesquelles le temps ($t_x$) entre l'instant de début de cette impulsion de la première valeur binaire et l'instant de début de l'impulsion précédente de la première valeur binaire est, moyennant certaines tolérances, égal à $\{(n * t_o) / 2\}$, où $t_o$ représente ledit temps le plus court de manière relative et n est un nombre naturel aléatoire pris parmi la série {3, 4, 5, 6, ...} et où les impulsions de non données sont les impulsions de la première valeur binaire pour lesquelles cette égalité ne s'applique pas.

**2.** Dispositif de mise en oeuvre du procédé de mesure selon la revendication 1, caractérisé par un moyen (8, 9) pour recevoir des signaux à l'extérieur d'un système de traitement d'information numérique (10) à tester ;

un moyen (11) pour comparer un signal reçu (3) à une valeur de seuil (5) et pour le convertir en un signal binaire (6) constitué par des impulsions d'une première valeur binaire tant que le signal reçu est supérieur à la première valeur de seuil et par des impulsions d'une seconde valeur binaire tant que le signal reçu est inférieur à la valeur de seuil ;

un moyen (13... 17) pour déterminer le temps le plus court de manière relative ($t_o$) entre deux instants de début consécutifs des

impulsions de la première valeur binaire ;

un moyen (18) pour déterminer le nombre d'impulsions de données, ces impulsions étant les impulsions de la première valeur binaire pour lesquelles s'applique le fait que le temps ($t_x$) entre l'instant de début de cette impulsion de la première valeur binaire et l'instant de début de l'impulsion précédente de la première valeur binaire est, moyennant certaines tolérances, égal à $\{(n * t_o) / 2\}$ où $t_o$ représente ledit temps le plus court de manière relative et n est un nombre naturel aléatoire pris parmi la série {3, 4, 5, 6, ...} et pour déterminer le nombre d'impulsions de non données, ces impulsions étant les impulsions de la première valeur binaire pour lesquelles cette égalité ne s'applique pas ; et

un moyen (18 ... 20) pour déterminer et représenter la valeur de caractéristique en question, laquelle valeur de caractéristique dépend d'un rapport entre un nombre d'impulsions de données et un nombre d'impulsions de non données.

**3.** Dispositif selon la revendication 2, caractérisé par :

un dispositif de conversion (13) pour convertir le signal binaire (6) en signal conformé en dents de soie (7) présentant des flancs ascendants croissant linéairement en fonction du temps et des flancs descendants brutalement à des instants correspondant aux instants de début des impulsions de la première valeur binaire du signal binaire ;

un dispositif (16, 17) pour déterminer l'amplitude de pic la plus faible de manière relative ($U_o$) du signal conformé en dents de scie (4) ;

un dispositif (18) pour détecter et compter le nombre de pics du signal conformé en dents de soie dont l'amplitude est, moyennant certains tolérances, égale à $\{(n * u_o) / 2\}$ où $u_o$ est ladite amplitude de pic la plus faible de manière relative ($u_o$) et n est un nombre naturel aléatoire pris parmi la série {3, 4, 5, 6, ...}.

**4.** Dispositif selon la revendication 3, caractérisé par un dispositif (19) pour comparer les valeurs de caractéristique respectives sur plus d'une période à considérer consécutive et pour déterminer la valeur la plus grande de cellesci.

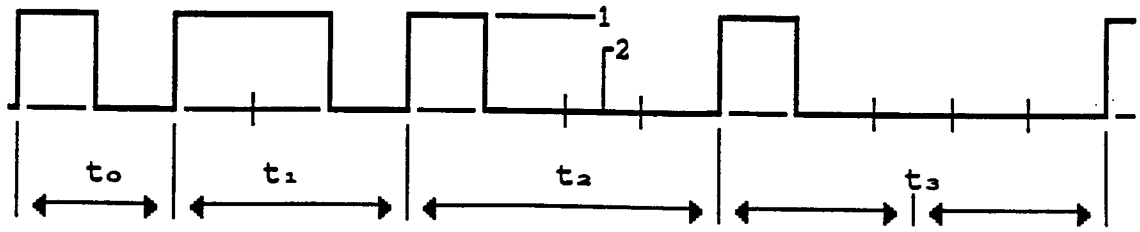


FIG. 1

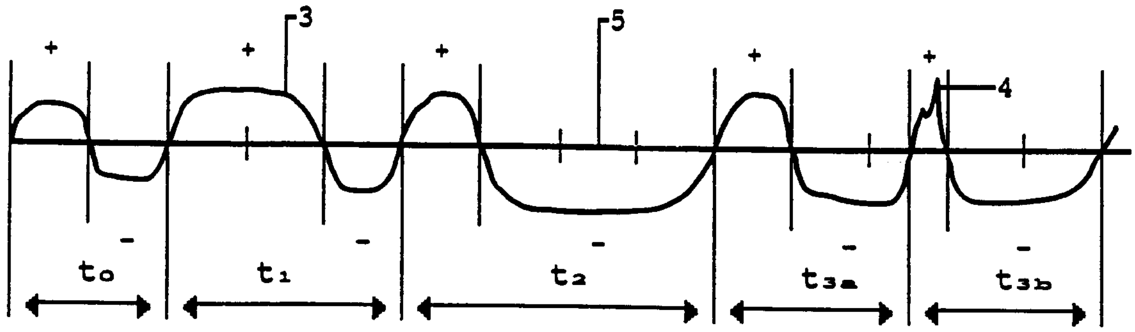


FIG. 2

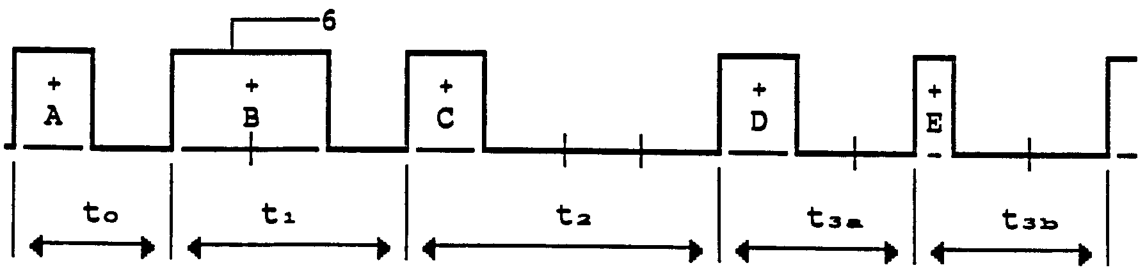


FIG. 3

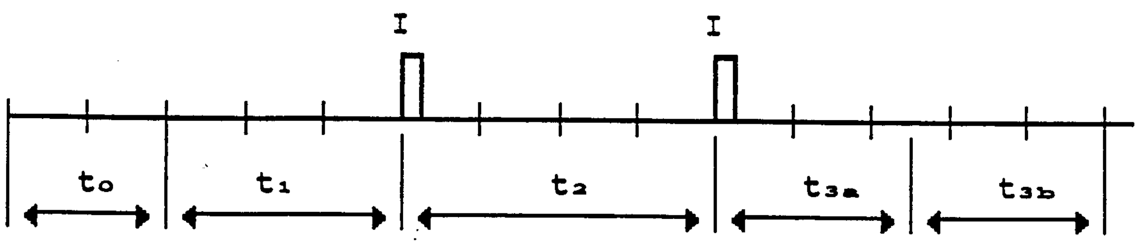


FIG. 4

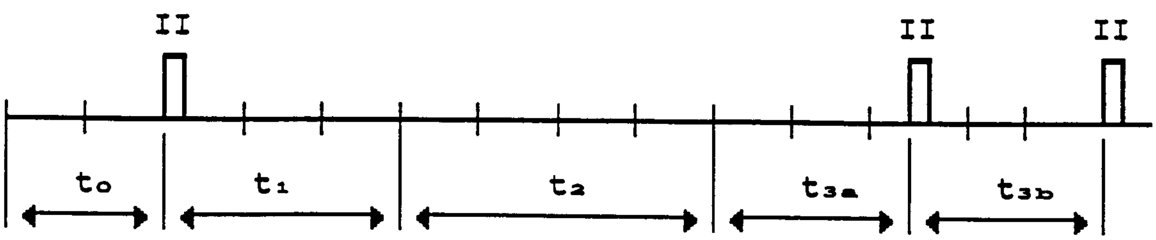


FIG. 5

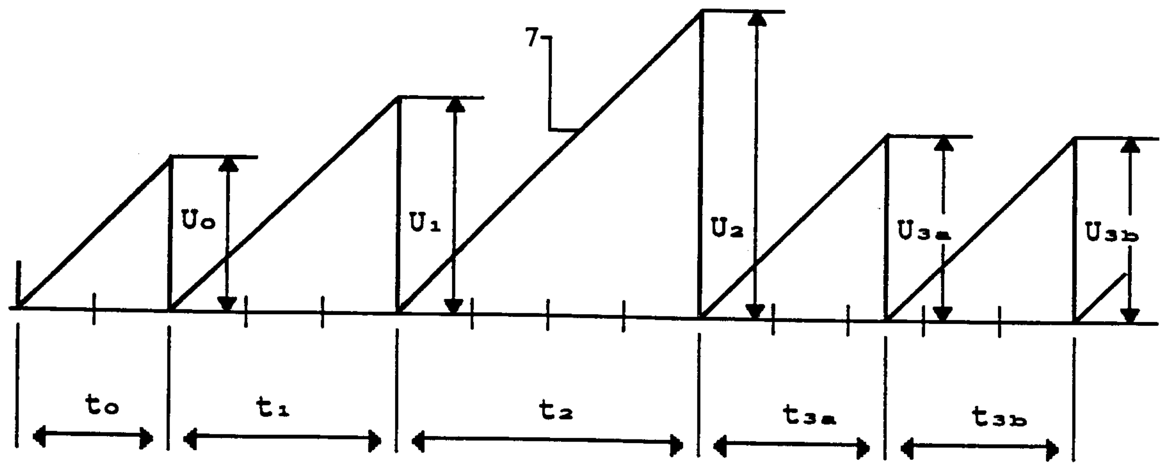
7
Uo
U1
U2
U3a
U3b
to
t1
t2
t3a
t3b

FIG. 6

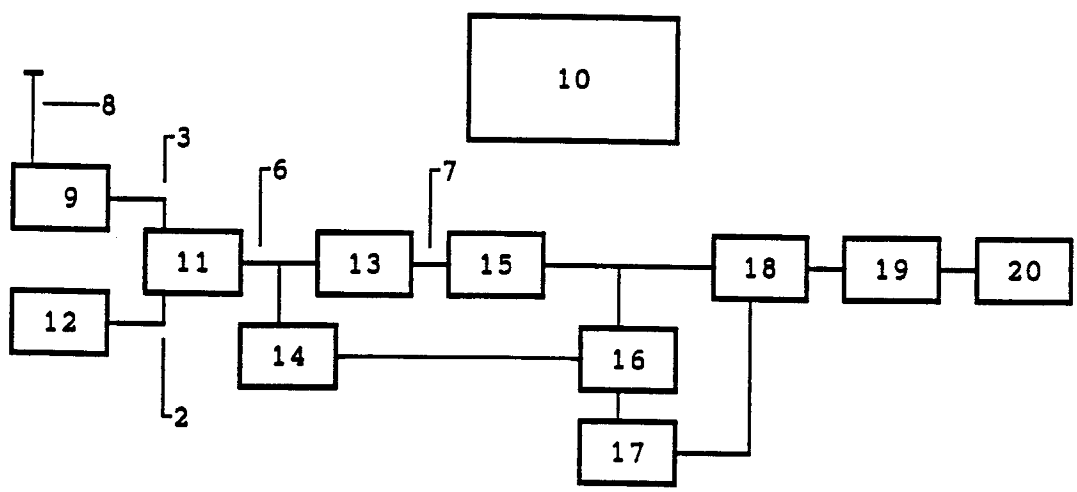
8
3
6
7
9
10
11
12
13
14
15
16
17
18
19
20
2

FIG. 7